# EUROPÄISCHE PATENTSCHRIFT

(11) **EP 1 055 253 B1**
(45) Veröffentlichungstag und Bekanntmachung des Hinweises auf die Patenterteilung: **13.11.2002**
(21) Anmeldenummer: 99908874.3
(22) Anmeldetag: 11.02.1999
(51) Int. Cl.: H01L 21/00

(54) **EINRICHTUNG ZUM BE- UND ENTLADEN VON SUBSTRATEN IN BZW. AUS EINEM REINRAUM**
DEVICE FOR LOADING SUBSTRATES INTO AND UNLOADING THEM FROM A CLEAN ROOM
DISPOSITIF POUR INTRODUIRE DES SUBSTRATS DANS UNE SALLE BLANCHE ET LES EN RETIRER

(30) Priorität: 12.02.1998 DE 19805624
(43) Veröffentlichungstag der Anmeldung: 29.11.2000
(73) Patentinhaber: BROOKS Automation GmbH, 07745 Jena (DE)
(72) Erfinder: SCHMUTZ, Wolfgang, D-78658 Zimmern (DE); GENTISCHER, Josef, D-73630 Remshalden (DE)
(74) Vertreter: Bertram, Helmut
(86) Internationale Anmeldenummer: EP9900883
(87) Internationale Veröffentlichungsnummer: WO99041771

(56) Entgegenhaltungen:
- EP-A- 0 735 573
- WO-A-97/02199
- US-A- 5 364 219

## Beschreibung

Die vorliegende Erfindung bezieht sich auf eine Einrichtung zum Be- und Entladen von Substraten in bzw. aus einem Reinraum nach dem Oberbegriff des Anspruchs 1.

Bei einer aus der EP-A-0735 573 bekannten Einrichtung dieser Art besitzt die Prozessanlage eine Handhabungsvorrichtung, mit der bei an die Schleusenöffnung angedockter Transportbox die Substrate aus der Transportbox in die Prozessanlage oder umgekehrt verbracht werden. Hierzu ist eine Adaptervorrichtung in Form eines Schildes vorgesehen, das die verschließbare Schleusenöffnung beinhaltet. Zur Höhenjustierung der Schleusenöffnung gegenüber der Prozessanlage ist das Schild vertikal einstellbar.

Aufgabe der vorliegenden Erfindung ist es, eine Einrichtung zum Be- und Entladen von Substraten in bzw. aus einem Reinraum der eingangs genannten Art zu schaffen, bei der eine auch bei einem Austausch der Schleusenvorrichtung noch gültige Justage der Schleusenvorrichtung gegenüber der Prozessanlage möglich ist.

Zur Lösung dieser Aufgabe sind bei einer Einrichtung zum Beund Entladen von Substraten in bzw. aus einem Reinraum der eingangs genannten Art die im Anspruch 1 angegebenen Merkmale vorgesehen.

Mit der erfindungsgemäßen Einrichtung ist erreicht, dass die rahmenartige Adaptervorrichtung gegenüber der Lage der Prozessanlage bzw. deren Handhabungsvorrichtung nur einmalig eingestellt bzw. justiert werden muss, da diese Adaptervorrichtung dann stets verbleibt und als einmal justierte Aufnahme für die Schleusenvorrichtung dient. Dies erspart erheblichen Arbeits- und Zeitaufwand dann, wenn die Schleusenvorrichtung, bspw. nach einer Fehleranzeige gegen eine andere ausgetauscht werden muss.

Mit den Merkmalen gemäß Anspruch 2 ist in vorteilhafter Weise erreicht, dass die Adaptervorrichtung in den gewünschten oder praktisch allen denkbaren Richtungen gegenüber der Prozessanlage justiert, d.h. bspw. vertikal bzw. horizontal gestellt werden kann.

Zum Einstellen der Adaptervorrichtung in Z-Richtung bzw. zum Neigen um die X-Achse, sind die Merkmale gemäß Anspruch 3 vorgesehen.

Mit den Merkmalen gemäß Anspruch 4 ist, insbesondere auch in Verbindung mit den Merkmalen des Anspruchs 5 eine Einstellung um die Y-Achse, in Richtung der X- und Y-Achse u.dgl. erreicht.

Zur entsprechenden Fixierung der Einstellung sind die Merkmale gemäß Anspruch 6 vorgesehen.

Die Verbindung der betreffenden Schleusenvorrichtung mit der Adaptervorrichtung wird in schneller und einfacher Weise mit den Merkmalen gemäß Anspruch 7 erreicht. Dabei ergibt sich eine einfache Austauschbarkeit der Schleusenvorrichtung anhand der Merkmale gemäß Anspruch 8.

In weiterer Ausgestaltung sind die Merkmale gemäß Anspruch 9 vorgesehen, die ein schnelles und einfaches vorpositioniertes Aufsetzen einer Transportbox auf den verschiebbaren, d.h. an die Schleusenöffnung andockbaren Aufnahmetisch ermöglichen. Wenn dabei die Merkmale gemäß Anspruch 10 und/oder 11 vorgesehen sind, kann die Transportbox in einfacher Weise sowohl von zwei oder drei seitlichen Richtungen als auch von oben her auf die Rollenbahn und damit auf den Aufnahmetisch gebracht werden. Eine definierte Haltelage der Transportbox auf der Rollenbahn ergibt sich durch die Merkmale gemäß Anspruch 12.

Konstruktiv zweckmäßig ist es, wenn die Rollenbahn gemäß den Merkmalen des Anspruchs 13 ausgebildet ist. Zweckmäßige weitere Ausgestaltungen der Rollenbahn ergeben sich dadurch aus den Merkmalen eines oder mehrerer der Ansprüche 14 bis 16.

In weiterer Ausgestaltung vorliegender Erfindung ist zur hermetischen Verschließbarkeit der Schleusenöffnung mittels der Schleusentür eine vorteilhafte Konstruktion nach den Merkmalen des Anspruchs 17 vorgesehen. Konstruktive Ausgestaltungen ergeben sich bei Vorhandensein der Merkmale nach Anspruch 18 und/oder 19.

Vorteile hinsichtlich konstruktivem und arbeitstechnischem Aufwand ergeben sich, wenn die Merkmale gemäß Anspruch 20 und/oder 21 vorgesehen sind.

weitere Einzelheiten der Erfindung sind der folgenden Beschreibung zu entnehmen, in der die Erfindung anhand des in der Zeichnung dargestellten Ausführungsbeispieles näher beschrieben und erläutert ist. Es zeigen:
- Figur 1: in teilweise geschnittener Seitenansicht eine Einrichtung zum Be- und Entladen von Substraten in bzw. aus einem Reinraum gemäß einem bevorzugten Ausführungsbeispiel vorliegender Erfindung,
- Figur 2: in teilweise abgebrochener Darstellung eine Ansicht längs der Linie II-II der Figur 1,
- Figur 3: eine teilweise geschnittene Ansicht gemäß Pfeil III der Figur 1,
- Figur 4: eine Draufsicht gemäß Pfeil IV der Figur 1, jedoch ohne Transportbox und
- Figur 5: einen Schnitt längs der Linie V-V der Figur 1.

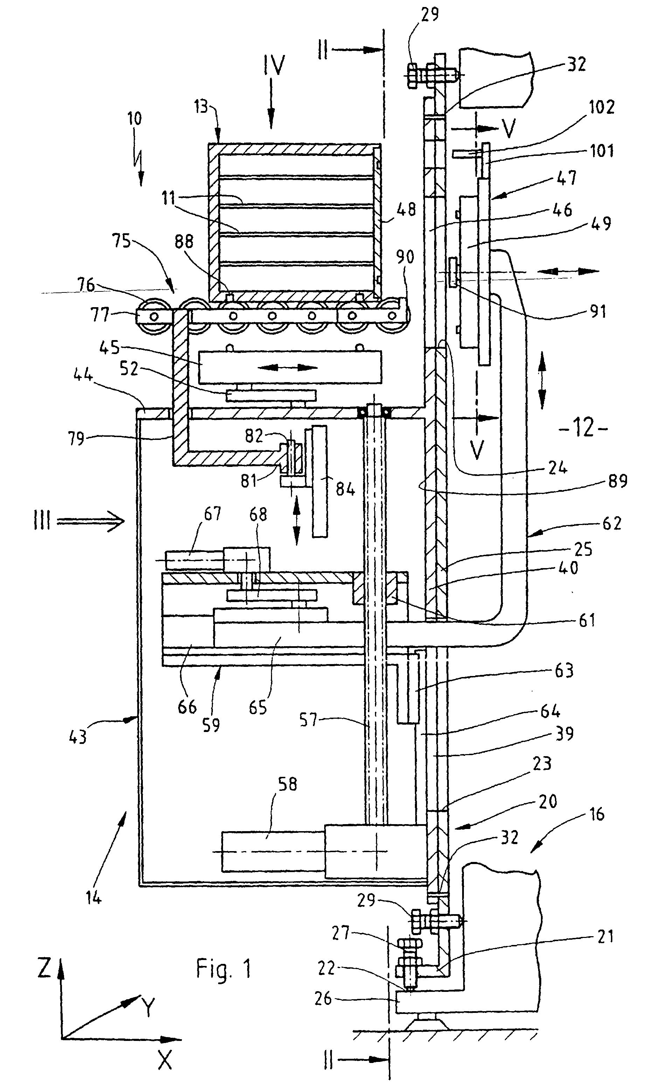

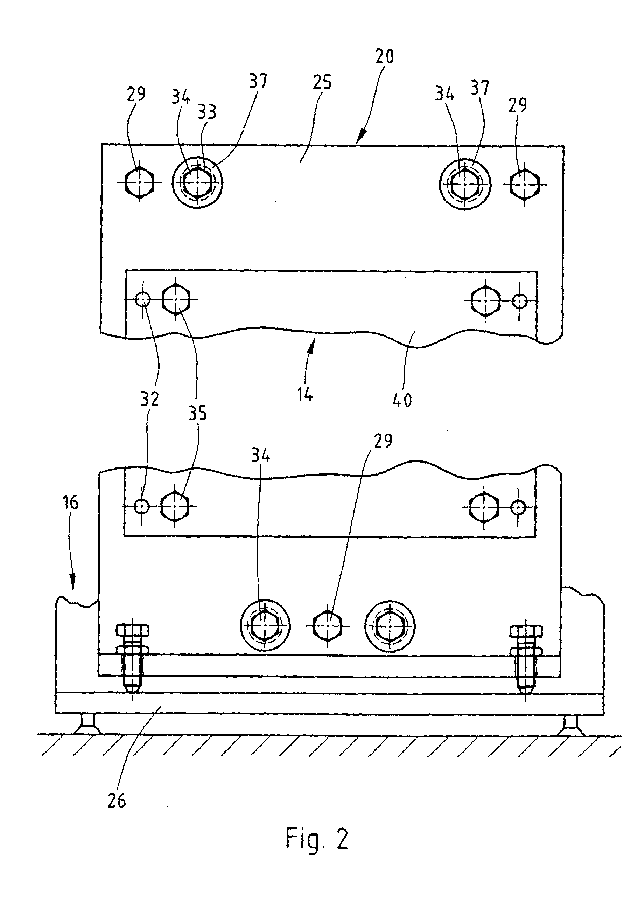

Gemäß den Figuren 1 und 2 besitzt die Einrichtung 10 zum Beund Entladen von Substraten 11 in bzw. aus einem Reinraum 12 eine, eine Transportbox 13 mit den Substraten 11 haltende bzw. aufnehmende Schleusenvorrichtung 14 zur Übergabe bzw. Übernahme der Substrate 11 an bzw. von einer den Reinraum 12 bildenden Prozessanlage 16, die in nicht dargestellter Weise eine Handhabungsvorrichtung zur Übernahme und Übergabe der Substrate 11 in die bzw. aus der Transportbox 13 aufweist.

Zur vertikalen und horizontalen Justierung der Schleusenvorrichtung 14 gegenüber der Prozessanlage 16 und unabhängig von deren ggf. nicht genau vertikal und/oder horizontal ausgerichteter Lage besitzt die Einrichtung 10 eine Adaptervorrichtung 20, die zwischen Schleusenvorrichtung 14 und Prozessanlage 16 angeordnet ist. Die Adaptervorrichtung 20 besitzt eine Basisplatte 25, die mit einer oberen Öffnung 24 und einer unteren Öffnung 23 versehenen ist. Die Basisplatte 25 sitzt verstellbar auf einer ortsfesten Leiste 26 auf, die hier Teil der Prozeßanlage 16 ist und an der sich zwei mit Kugelrollen 22 versehene vertikale Abdrückschrauben 27 abstützen, die im Abstand an einem Winkelteil 21 der Basisplatte 25 vertikal ein- und ausschraubbar gehalten sind. Die Basisplatte 25 ist auf der Leiste 26 sowohl in horizontaler X-Richtung als auch in dazu quer verlaufender horizontaler Y-Richtung verschiebbar. Durch die Verstellbarkeit jeder der Abdrückschrauben 27 ist die Basisplatte 25 auch in vertikaler Z-Richtung bewegbar und gegenüber dieser neigbar. Die Basisplatte 25 ist an einem oberen und unteren Bereich 22 und 23 mit im Abstand angeordneten ein- und ausschraubbaren Abdrückschrauben 29 versehen, die sich in montiertem Zustand an einer Fläche der Prozessanlage 16 abstützen. Durch Verstellen jeder der Abdrückschrauben 29 kann eine Ausrichtung der Basisplatte 25 gegenüber der Prozeßanlage 16 erfolgen, wobei eine Schwenkbewegung der Basisplatte 25 gegenüber der X- und/oder Y-Achse möglich ist.

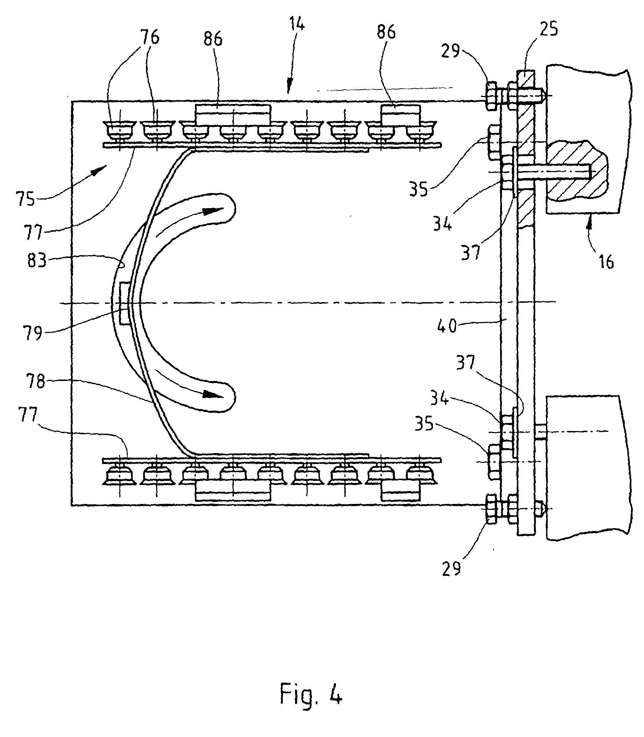

Die Basisplatte 25 besitzt nahe den Abdrückschrauben 29 durchmessergroße Bohrungen 33, die von in Gewindebohrungen 36 benachbarten Teils der Prozeßanlage 16 einschraubbaren durchmesserkleineren Befestigungsschrauben 34 durchdrungen sind, deren Kopf sich an einer Unterlegscheibe 37 abstützt (Figur 4). Dadurch ist eine Verstellung im bspw. mm-Bereich möglich und es kann die gegenüber der Prozessanlage 16 justierte Lage der Adaptervorrichtung 20 fixiert werden.

Die Basisplatte 25 der Adaptervorrichtung 20 ist mit hier bspw. vier Indexierstiften 32 und Gewindebohrungen bestückt. Eine vertikale Grundplatte 40 der Schleusenvorrichtung 14 besitzt in einem entsprechenden Bohrbild Bohrungen zur im Wesentlichen spielfreien Aufnahme der Indexierstifte 32 und Schrauben 35 zum Einschrauben in die Gewindebohrung.

Durch die Justierung der Adaptervorrichtung 20 gegenüber der Prozessanlage 16 und die lösbar einsteckbare Verbindung mit der Schleusenvorrichtung 14 ist es ohne weitere Justagemaßnahmen möglich, die Schleusenvorrichtung 14 gegen eine andere an ihrer Grundplatte 40 mit demselben Bohrbild ausgestattete Schleusenvorrichtung zu ersetzen. Dabei liegen Grundplatte 40 und Basisplatte 25 flächig aneinander.

Gemäß Figur 1 besitzt die Schleusenvorrichtung 14 ein Gehäuse 43, das frontseitig von der Grundplatte 40, die das Gehäuse 43 obenseitig überragt, abgeschlossen ist. Die obere Abdeckung des Gehäuses 43 ist durch eine Trägerplatte 44 gebildet, oberhalb der ein Aufnahmetisch 45 für eine Transportbox 13 gehalten ist. Der Aufnahmetisch 45 ist in noch zu beschreibender Weise zur vertikalen Grundplatte 40 hin und her bewegbar und an diese mit der Transportbox 13 andockbar.

Die Grundplatte 40 besitzt ein Schleusenfenster 46, das mit der koaxialen Öffnung 24 der Basisplatte 25 fluchtet und die beide mit einer Schleusentür 47 verschließbar sind. Zum Schleusenfenster 46 koaxial besitzt die Transportbox 13 eine Öffnung 48, die mit einem Deckel 49 hermetisch verschließbar ist. Zur Übernahme bzw. Übergabe der Substrate 11 aus bzw. in die Transportbox 13 wird die Transportbox 13 zur Grundplatte 40 hin verfahren. Mit Hilfe der Schleusentür 47 wird in noch zu beschreibender Weise der Deckel 49 von der Transportbox 13 entriegelt, abgenommen und mit der Schleusentür 47 verbunden. Ist die Schleusentür 47 mit dem Deckel 49 aus dem Bereich des Schleusenfensters 46 verfahren, können mit Hilfe der nicht dargestellten Handhabungsvorrichtung die Substrate 11 aus der Transportbox 13 entnommen und zur Prozessanlage 16 (in den Reinraum 12) gebracht werden bzw. umgekehrt. Es versteht sich, dass nach dem Beladen der Transportbox 13 in entsprechend umgekehrter Weise der Deckel 49 mit der Transportbox 13 zur hermetischen Verschließung von deren Öffnung 48 verbunden und von der Schleusentür 47 entriegelt und abgenommen wird.

Innerhalb des Gehäuses 43 der Schleusenvorrichtung 14 sind sämtliche für die Bewegung von Aufnahmetisch 45 und Schleusentür 47 notwendigen Antriebs- und Übertragungsorgane angeordnet. An der Unter- bzw. Innenseite der Trägerplatte 44 ist ein nicht dargestellter Getriebemotor angeflanscht, der über ein Kurbelgetriebe 52 mit dem Aufnahmetisch 45 zu dessen horizontaler Hin- und Herbewegung verbunden ist. Hierfür besitzt das Kurbelgetriebe 52 eine Kurbelrolle, die in eine untere kreisförmige Nut des Aufnahmetisches 45 eingreift, so dass der Aufnahmetisch 45 entlang Schienen bewegt werden kann.

In der Trägerplatte 44 ist eine Gewindespindel 57 gelagert, die senkrecht nach unten steht und bodenseitig von einem Getriebemotor 58 antreibbar ist. Ein Schlittengehäuse 59 ist über eine Mutter 61 längs der Gewindespindel 57 auf und ab verfahrbar. Das zur Grundplatte 40 hin offene Schlittengehäuse 59 nimmt den horizontalen Teil eines L-förmigen Armes 62 auf, an dessen vertikalem Armende die Schleusentür 47 befestigt ist. Das Schlittengehäuse 59 besitzt der Mutter 61 abgewandt einen Schlitten 63, der längs einer vertikalen Führung 64, die an der Grundplatte 40 gehalten ist, vertikal verfahrbar geführt ist. Der horizontale Teil des L-förmigen Armes 62, der die Öffnung 23 der Basisplatte 25 und eine Öffnung 39 der Grundplatte 40 durchdringt, ist endseitig als Schlitten 65 ausgeführt, welcher an einer horizontalen Führung 66 des Schlittengehäuses 59 in horizontaler Richtung hin und her verfahrbar geführt ist. Das horizontale Verfahren des L-förmigen Armes 62 erfolgt mittels eines auf dem Schlittengehäuse 59 angeflanschten Getriebemotors 67, der ein Kurbelgetriebe 68 antreibt, deren Kurbelrolle in eine kreisförmige Nut des Schlittenteils 65 des L-förmigen Armes 62 lose eingreift. Auf diese Weise wird mit Hilfe des Getriebemotors 67 die Schleusentür 47 horizontal zum Schleusenfenster 46 bzw. zur Öffnung 24 hin und weg verfahren, während mit Hilfe des Getriebemotors 58 der L-förmige Arm 62 und damit die Schleusentür 47 in vertikaler Richtung aus bzw. in den Bereich des Schleusenfensters 46 verfahren werden kann.

Gemäß den Figuren 1, 3 und 4 besitzt die Schleusenvorrichtung 14 im Bereich des Aufnahmetisches 45 eine Rollenbahn 75, die zu beiden Längsseiten des Aufnahmetisches 45 mit Rollen 76 bestückte parallele Rollenleisten 77 aufweist. Die beiden Rollenleisten 77 sind durch eine gewölbte U-förmige Schiene 78 starr miteinander verbunden. Die U-förmige Schiene 78 ist in einem mittigen Bereich zwischen den beiden Rollenleisten 77 mit dem oberen Ende eines winkelförmigen Hebels 79 fest verbunden, dessen senkrechter Teil durch die Trägerplatte 44 hindurchgeführt und dessen unterer rückgeführter horizontaler Teil an seinem freien Ende eine Lagerbuchse 81 trägt, durch welche eine vertikale Achse 82 geführt ist. Die Trägerplatte 44 ist mit einer halbkreisförmigen Ausnehmung 83 versehen, durch die der Hebel 79 dringt und deren Radius dem Schwenkradius des Hebels 79 um die Achse 82 entspricht. Die die Lagerbuchse 81 aufnehmende Achse 82 ist an einer ortsfest gehaltenen Führung 84 in vertikaler Richtung auf und ab geführt. Die Schwenkbewegung und die vertikale Auf- und Abbewegung des Hebels 79 sind in zum Teil nicht dargestellter Weise motorisch ausgeführt. Die Hubbewegung der Rollenbahn 75 erfolgt bspw. durch eine bereits erwähnte Anordnung aus Getriebemotor 71 und Kurbelgetriebe 72. Durch die Schwenkbewegung des Hebels 79 um die Achse 82 kann die Rollenbahn 75 aus einer zur Grundplatte 40 bzw. dem Schleusenfenster 46 hin gerichteten Lage in eine um 90° in die eine oder andere Schwenkrichtung bewegte Lage gebracht werden. Auf diese Weise kann eine Transportbox 13 aus drei zueinander senkrechten oder beliebigen dazwischen liegenden Richtungen horizontal auf die Rollenbahn 75 gebracht werden. Die Rollenleisten 77 der Rollenbahn 75 besitzen bspw. jeweils an zwei beabstandeten Bereichen senkrecht nach oben abstehende Einführungsschrägen 86, die ein Absetzen einer Transportbox 13 von oben auf die Rollenbahn 75 ermöglichen. Durch das Ablegen bzw. Aufrollen einer Transportbox 13 auf die Rollenbahn 75 ist eine Vorspositionierung der Transportbox 13 gegenüber dem Aufnahmetisch 45 erreicht.

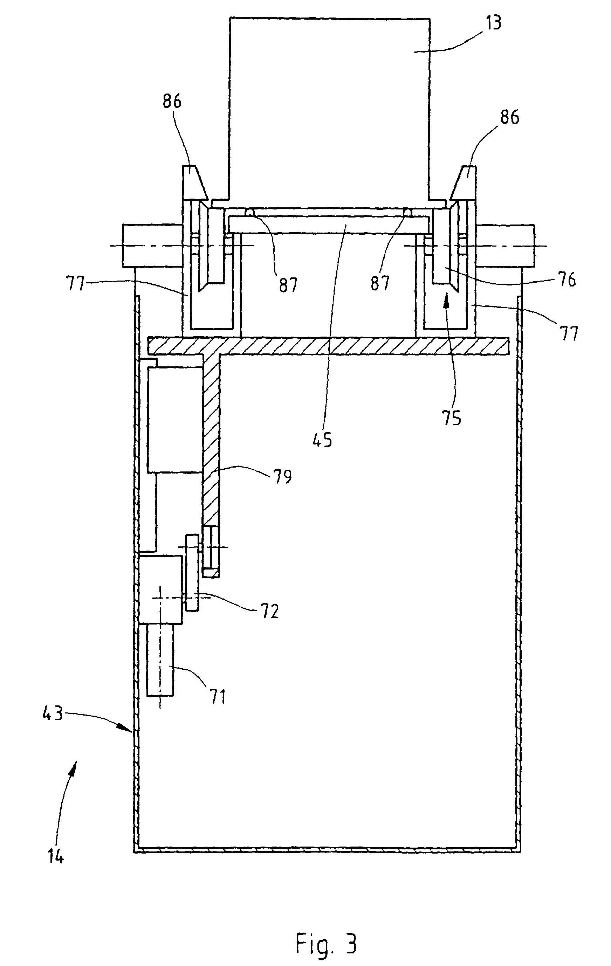

Die Rollenbahn 75 kann aufgrund der Führung 84 für die Achse 82 gegenüber dem Aufnahmetisch 45 angehoben bzw. abgesenkt werden. In angehobener Stellung (Figur 1) wird eine Transportbox 13 auf die Rollenbahn 75 gebracht oder von dieser weggefahren oder abgehoben. In abgesenkter Position (Figur 3) greifen am Aufnahmetisch 45 vorgesehene und mit Abstand angeordnete Fixierstifte 87 in entsprechende Aufnahmesacklochbohrungen 88 an der Unterseite der Transportbox 13 ein, so dass die exakte Positionierung der Transportbox 13 auf dem Aufnahmetisch 45 erreicht ist. Beim dargestellten Ausführungsbeispiel sind bspw. drei in einer Dreieckanordnung vorgesehene Fixierstifte 87 vorhanden.

Die beiden Rollenleisten 77 der Rollenbahn 75 sind mit einem leichten Gefälle derart versehen, dass eine Neigung zur Andock- bzw. Beladeebene 89 erreicht ist, wobei an diesem Ende eine oder beide Rollenleisten 77 mit einem Anschlag 90 versehen sind.

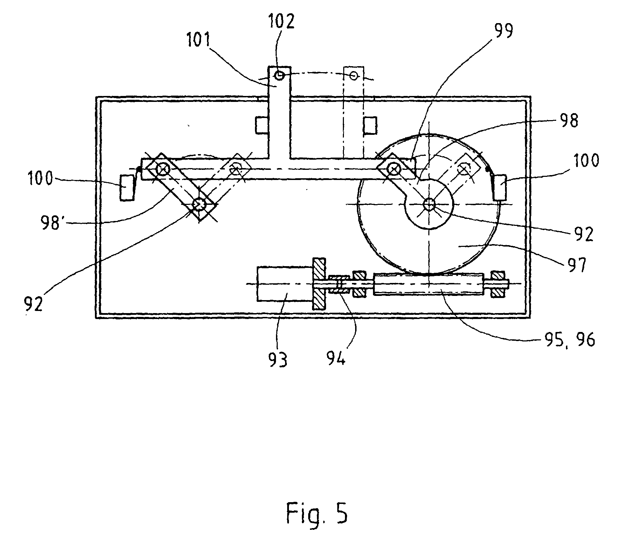

Figur 5 zeigt den Verriegelungsmechanismus für den bzw. des Deckels 49 mit der Transportbox 13. Zwei im Abstand angeordnete T-förmige Schlüssel sind an jeweils einer ortsfesten Achse 92 schwenkbar gehalten. Der Antrieb erfolgt über einen Getriebemotor 93, der über eine Kupplung 94 und eine Schneckenwelle 95 mit einem Schneckenrad 96 verbunden ist. Mit dem Schneckenrad 96 ist über Kraftschluss eine Kupplungsscheibe 97 verbunden, die mit einem ersten Kurbelhebel 98 drehfest verbunden ist, welcher über eine Gelenkstange 99 mit einem zweiten Kurbelhebel 98' verbunden ist. Auf diese Weise ist ein Parallelogrammgetriebe erreicht. Die Bewegung der Gelenkstange 99 wird durch Anschläge 100 und 100', die mit Endschaltern versehen sind, begrenzt. Die Gelenkstange 99 weist etwa mittig einen Hebelansatz 101 auf, der seitlich nach außerhalb des Deckels 49 geführt ist und der es ermöglicht, beim Ausfall des motorischen Antriebs den Öffnungs- oder Schließvorgang von Hand gegen den Kraftschluss des blockierten Getriebes und der natürlichen Öffnungs- oder Schließkraft vorzunehmen bzw. zu beenden. Der Ansatz 101 ist durch eine seitliche Öffnung der Schleusentür 47 geführt und kann über einen damit verbundenen Bolzen 102 betätigt werden. Wie ersichtlich, ist diese Verriegelungsmechanik innerhalb der Schleusentür 47 angeordnet, so dass sie beim Ansetzen oder Absetzen des Deckels 49 axial mit den Schlüsseln 91 verbunden bzw. von diesen gelöst wird.

## Patentansprüche

1. Einrichtung (10) zum Be- und Entladen von Substraten (11) in bzw. aus einem Reinraum (12), mit einer Schleusenvorrichtung (14), auf die eine Transportbox (13) zur Aufnahme der Substrate (11) bringbar ist und die mit einer hermetisch verschließbaren Schleusenöffnung (46) versehen ist, und mit einer der Schleusenöffnung (46) benachbarten Prozessanlage (16), zwischen der und der Schleusenvorrichtung (14) eine Adaptervorrichtung (20) an der Prozessanlage gehalten und gegenüber der Prozessanlage (16) einstellbar ausrichtbar ist, **dadurch gekennzeichnet, dass** die Schleusenvorrichtung (14) an der Adaptervorrichtung (20) lösbar fixierbar ist.

2. Einrichtung nach Anspruch 1, **dadurch gekennzeichnet, dass** die Adapter Vorrichtung (20) gegenüber der Prozessanlage (16) in der Höhe (Z-Achse) einstellbar und/oder gegenüber einer senkrechten Achse (X-Achse) und/oder einer horizontalen Achse (Y-Achse) neigbar und/oder in einer oder beiden Achsen (X,Y) verschiebbar ist.

3. Einrichtung nach Anspruch 1 oder 2, **dadurch gekennzeichnet, dass** die Adaptervorrichtung (20) an ihrer Unterseite mit zwei im Abstand angeordneten höhenverstellbaren Abdrückschrauben (27) verbunden ist, die auf einem ortsfesten Element (26) gehalten sind.

4. Einrichtung nach mindestens einem der vorhergehenden Ansprüche, **dadurch gekennzeichnet, dass** die Adaptervorrichtung (20) der Prozessanlage (16) zugewandt mit verstellbaren Abdrückschrauben (29) versehen ist, die sich an einem Bauteil der Prozessanlage (16) abstützen.

5. Einrichtung nach den Ansprüchen 3 und 4, **dadurch gekennzeichnet, dass** die Adaptervorrichtung (20) mittels der Abdrückschrauben (27) auf dem Element (26) längs und/oder quer verschiebbar gelagert ist.

6. Einrichtung nach mindestens einem der vorhergehenden Ansprüche, **dadurch gekennzeichnet, dass** die Adaptervorrichtung (20) mittels Befestigungsschrauben (34), die durchmessergrößere Bohrungen (33) durchdringen, an der Prozeßanlage (16) fixierbar ist.

7. Einrichtung nach mindestens einem der vorhergehenden Ansprüche, **dadurch gekennzeichnet, dass** die Adaptervorrichtung (20) mit beabstandeten Indexierstiften (32) versehen ist, die in Aufnahmebohrungen (41) der Schleusenvorrichtung (14) im Wesentlichen spielfrei passend einsteckbar sind.

8. Einrichtung nach Anspruch 7, **dadurch gekennzeichnet, dass** die Schleusenvorrichtung (14) eine Grundplatte (40) aufweist, die ein der Anordnung der Indexierstifte (32) in der Adaptervorrichtung (20) entsprechendes Bohrbild aufweist.

9. Einrichtung nach mindestens einem der vorhergehenden Ansprüche, bei der die Schleusenvorrichtung (14) einen verschiebbaren Aufnahmetisch (45) für die Transportbox (13) aufweist, **dadurch gekennzeichnet, dass** die Schleusenvorrichtung (14) im Bereich des Aufnahmetisches (45) eine Rollenbahn (75) aufweist.

10. Einrichtung nach Anspruch 9, **dadurch gekennzeichnet, dass** die Rollenbahn (75) um eine senkrechte Achse (82) um vorzugsweise ± 90° schwenkbar ist.

11. Einrichtung nach Anspruch 9 oder 10, **dadurch gekennzeichnet, dass** die Rollenbahn (75) mit nach oben ragenden seitlichen Einführungsschrägen (86) versehen ist.

12. Einrichtung nach mindestens einem der Ansprüche 9 bis 11, **dadurch gekennzeichnet, dass** die Rollenbahn (75) in Richtung zur Prozessanlage (16) zu einer horizontalen Be- bzw. Entladeebene leicht geneigt ist und einen Anschlag (90) aufweist.

13. Einrichtung nach mindestens einem der Ansprüche 9 bis 12, **dadurch gekennzeichnet, dass** die Rollenbahn (75) durch zwei parallele Bahnteile (77) gebildet ist, die zu beiden Seiten des Aufnahmetisches (45) verlaufen und die mit einem Bügel (79) verbunden sind.

14. Einrichtung nach den Ansprüchen 10 und 13, **dadurch gekennzeichnet, dass** der Verbindungsbügel (78) mit einem Hebel (79) verbunden ist, dessen anderes Ende an einer senkrechten Achse (82) schwenkbar gehalten ist.

15. Einrichtung nach mindestens einem der Ansprüche 9 bis 14, **dadurch gekennzeichnet, dass** die Rollenbahn (75) gegenüber der Oberfläche des Aufnahmetisches (45) anhebbar und absenkbar ist.

16. Einrichtung nach den Ansprüchen 14 oder 15 mit 14, **dadurch gekennzeichnet, dass** der Hebel (79) bzw. die Schwenkachse (82) höhenverfahrbar ist.

17. Einrichtung nach mindestens einem der vorhergehenden Ansprüche, bei der die Schleusenöffnung (46) der Schleusenvorrichtung (14) mit einer Schleusentür (47) hermetisch verschließbar ist, die mit einem Deckel (49) der Transportbox (13) verbindbar ist, **dadurch gekennzeichnet, dass** der Deckel (49) mit zwei T-förmigen Schlüsseln versehen ist, die mittels eines in der Schleusentür (47) gehaltenen Parallelogrammantriebs drehbar sind.

18. Einrichtung nach Anspruch 17, **dadurch gekennzeichnet, dass** mit dem Parallelogrammantrieb eine Kupplungsscheibe (97) verbunden ist, die von einem motorisch angetriebenen Schneckengetriebe bewegt ist.

19. Einrichtung nach Anspruch 17 oder 18, **dadurch gekennzeichnet, dass** der Parallelogrammantrieb eine Gelenkverbindungsstange (99) aufweist, von der ein von außen zugänglicher Handhebel (101) abragt.

20. Einrichtung nach einem der Ansprüche 9 bis 16 mit einem der Anspruche 17 bis 19, **dadurch gekennzeichnet, dass** die Schließbewegung der Schleusentür (47), die Verschiebebewegung des Aufnahmetisches (45) und die Absenkbewegung der Rollenbahn (75) von einem gleichartigen Kurbelantrieb abgeleitet ist.

21. Einrichtung nach Anspruch 20, **dadurch gekennzeichnet, dass** die Antriebseinheiten für die Schließbewegung der Schleusentür (47), für die Verschiebebewegung des Aufnahmetisches (45) und für die Absenkbewegung der Rollenbahn (75) und der Schleusentür (47) innerhalb der Schleusenvorrichtung (14) angeordnet sind.

## Claims

1. Apparatus (10) for loading substrates (11) into and unloading them from a clean room (12), with a lock device (14) onto which a transport box (13) to receive the substrates (11) can be placed and which is provided with a hermetically closable lock opening (46), and with a processing installation (16) adjacent to the lock opening (46), wherein an adapter device (20) can be retained on the processing unit between the processing unit and the lock device (14) and can be adjustably oriented relative to the processing unit (16), **characterised in that** the lock device (14) can be releasably fixed on the adapter device (20).

2. Apparatus as claimed in Claim 1, **characterised in that** the adapter device (20) is adjustable in height (Z axis) relative to the processing unit (16) and/or can be inclined relative to a vertical axis (X axis) and/or a horizontal axis (Y axis) and/or can be displaced in one or both axes (X, Y).

3. Apparatus as claimed in Claim 1 or 2, **characterised in that** the adapter device (20) is connected on its underside to two height-adjustable forcing screws (27) which are spaced apart and are retained on a stationary element (26).

4. Apparatus as claimed in at least one of the preceding claims, **characterised in that** the adapter device (20) is provided facing the processing unit (16) with adjustable forcing screws (29) which are supported on a component of the processing unit (16).

5. Apparatus as claimed in Claims 3 and 4, **characterised in that** the adapter device (20) is mounted on the element (26) by means of the forcing screws (27) so as to be longitudinally and/or transversely displaceable.

6. Apparatus as claimed in at least one of the preceding claims, **characterised in that** the adapter device (20) can be fixed on the processing unit (16) by means of fixing screws (34) which penetrate through bores (33) of larger diameter.

7. Apparatus as claimed in at least one of the preceding claims, **characterised in that** the adapter device (20) is provided with spaced indexing pins (32) which can be inserted into receiving bores (41) in the lock device (14) so that they fit substantially without play.

8. Apparatus as claimed in Claim 7, **characterised in that** the lock device (14) has a base plate (40) which has a pattern of holes corresponding to the arrangement of indexing pins (32) in the adapter device (20).

9. Apparatus as claimed in at least one of the preceding claims, in which the lock device (14) has a displaceable receiving table (45) for the transport box (13), **characterised in that** the lock device (14) has a roller track (75) in the region of the receiving table (45).

10. Apparatus as claimed in Claim 9, **characterised in that** the roller track (75) is pivotable about a vertical axle (82) by preferably ± 90°.

11. Apparatus as claimed in Claim 9 or 10, **characterised in that** the roller track (75) is provided with lateral lead-in slopes (86) which project upwards.

12. Apparatus as claimed in at least one of Claims 9 to 11, **characterised in that** the roller track (75) is slightly inclined in the direction of the processing unit (16) relative to a horizontal loading and unloading plane and has a stop (90).

13. Apparatus as claimed in at least one of Claims 9 to 12, **characterised in that** the roller track (75) is formed by two parallel track parts (77) which extend on both sides of the receiving table (45) and are connected to a bracket (79).

14. Apparatus as claimed in Claims 10 and 13, **characterised in that** the connecting bracket (78) is connected to a lever (79), the other end of which is pivotably retained on a vertical axle (82).

15. Apparatus as claimed in at least one of Claims 9 to 14, **characterised in that** the roller track (75) can be raised and lowered relative to the surface of the receiving table (45).

16. Apparatus as claimed in Claims 14 or 15 with 14, **characterised in that** the lever (79) or the pivot axle (82) is adjustable in height.

17. Apparatus as claimed in at least one of the preceding claims, in which the lock opening (46) of the lock device (14) can be hermetically closed by a lock door (47) which can be connected to a cover (49) of the transport box (13), **characterised in that** the cover (49) is provided with two T-shaped keys which can be turned by means of a parallelogram drive retained in the lock door (47).

18. Apparatus as claimed in Claim 17, **characterised in that** a clutch disc (97) which is moved by a motor-driven worm gear is connected to the parallelogram drive.

19. Apparatus as claimed in Claim 17 or 18, **characterised in that** the parallelogram drive has a linkage rod (99) from which an externally accessible hand lever (101) projects.

20. Apparatus as claimed in one of Claims 9 to 16 with Claims 17 to 19, **characterised in that** the closing movement of the lock door (47), the displacing movement of the receiving table (45) and the lowering movement of the roller track (75) is derived from a similar crank drive.

21. Apparatus as claimed in Claim 20, **characterised in that** the drive units for the closing movement of the lock door (47), for the displacing movement of the receiving table (45) and for the lowering movement of the roller track (75) and the lock door (47) are disposed within the lock device (14).

## Revendications

1. Dispositif (10) de chargement et déchargement de substrats (11) dans une salle blanche (12) ou de celle-ci, comportant un dispositif à sas (14) sur lequel peut être amenée une boîte de transport (13) destinée à recevoir les substrats (11), et qui est pourvu d'une ouverture de sas (46) pouvant être fermée hermétiquement, et comportant une installation de processus (16) voisine de l'ouverture de sas (46), entre laquelle et le dispositif à sas (14), un dispositif d'adaptation (20) est maintenu sur l'installation de processus et peut être orienté de manière réglable par rapport à l'installation de processus (16), **caractérisé en ce que** le dispositif à sas (14) peut être fixé de manière séparable au dispositif d'adaptation (20).

2. Dispositif selon la revendication 1, **caractérisé en ce que** le dispositif d'adaptation (20) est réglable en hauteur (axe Z) par rapport à l'installation de processus (16) et/ou est inclinable par rapport à un axe vertical (axe X) et/ou à un axe horizontal (axe Y) et/ou peut coulisser dans l'un ou les deux axes (X-Y).

3. Dispositif selon la revendication 1 ou 2, **caractérisé en ce que** le dispositif d'adaptation (20) est relié, sur son côté inférieur, à deux vis de pression (27) disposées à distance et réglables en hauteur, qui sont maintenues sur un élément fixe (26).

4. Dispositif selon l'une au moins des revendications précédentes, **caractérisé en ce que** le dispositif d'adaptation (20), tourné vers l'installation de processus (16), est pourvu de vis de pression (29) réglables qui prennent appui contre un composant de l'installation de processus (16).

5. Dispositif selon les revendications 3 et 4, **caractérisé en ce que** le dispositif d'adaptation (20) est monté, au moyen des vis de pression (27), de manière à pouvoir coulisser sur l'élément (26), longitudinalement et/ou transversalement.

6. Dispositif selon l'une au moins des revendications précédentes, **caractérisé en ce que** le dispositif d'adaptation (20) peut être fixé à l'installation de processus (16) au moyen de vis de fixation (34) qui traversent des perçages (33) de diamètre plus grand.

7. Dispositif selon l'une au moins des revendications précédentes, **caractérisé en ce que** le dispositif d'adaptation (20) est pourvu de doigts d'indexation (32) écartés qui peuvent être enfoncés de manière ajustée, sensiblement sans jeu, dans des perçages de réception (41) du dispositif à sas (14).

8. Dispositif selon la revendication 7, **caractérisé en ce que** le dispositif à sas (14) comporte une plaque de base (30) qui présente un modèle de perçage correspondant à la disposition des doigts d'indexation (32) dans le dispositif d'adaptation (20).

9. Dispositif selon l'une au moins des revendications précédentes, dans lequel le dispositif à sas (14) comporte une table de réception (45) coulissante pour la boîte de transport (13), **caractérisé en ce que** le dispositif à sas (14) comporte une voie à rouleaux (75) dans la zone de la table de réception (35).

10. Dispositif selon la revendication 9, **caractérisé en ce que** la voie à rouleaux (75) peut pivoter de préférence de ± 90° autour d'un axe vertical (82).

11. Dispositif selon la revendication 9 ou 10, **caractérisé en ce que** la voie à rouleaux (75) est pourvue de surfaces obliques d'introduction (96) latérales dirigées vers le haut.

12. Dispositif selon l'une au moins des revendications 9 à 11, **caractérisé en ce que** la voie à rouleaux (75) est légèrement inclinée en direction de l'installation de processus (16) par rapport à un plan horizontal de chargement ou déchargement, et comporte une butée (90).

13. Dispositif selon l'une au moins des revendications 9 à 12, **caractérisé en ce que** la voie à rouleaux (75) est formée par deux parties de voie (77) parallèles qui s'étendent des deux côtés de la table de réception (45) et qui sont reliées à un étrier (79).

14. Dispositif selon les revendications 10 et 13, **caractérisé en ce que** l'étrier de liaison (78) est relié à un levier (79) dont l'autre extrémité est maintenue pivotante sur un axe vertical (82).

15. Dispositif selon l'une au moins des revendications 9 à 14, **caractérisé en ce que** la voie à rouleaux (75) peut être relevée et abaissée par rapport à la surface de la table de réception (45).

16. Dispositif selon les revendications 14 ou 15 en combinaison avec la revendication 14, **caractérisé en ce que** le levier (79) ou l'axe de pivotement (82) est déplaçable en hauteur.

17. Dispositif selon l'une au moins des revendications précédentes, dans lequel l'ouverture de sas (46) du dispositif à sas (14) peut être fermée hermétiquement au moyen d'une porte de sas (47) qui peut être reliée à un couvercle (49) de la boîte de transport (13), **caractérisé en ce que** le couvercle (49) est pourvu de deux clés en forme de T qui peuvent tourner au moyen d'un dispositif d'entraînement à parallélogramme maintenu dans la porte de sas (47).

18. Dispositif selon la revendication 17, **caractérisé en ce qu'**au dispositif d'entraînement à parallélogramme est relié un disque d'accouplement (97) qui est déplacé par un mécanisme à vis sans fin entraîné par un moteur.

19. Dispositif selon la revendication 17 ou 18, **caractérisé en ce que** le dispositif d'entraînement à parallélogramme comporte une barre de liaison articulée (99) de laquelle dépasse un levier manuel (101) accessible de l'extérieur.

20. Dispositif selon l'une des revendications 9 à 16, en combinaison avec l'une des revendications 17 à 19, **caractérisé en ce que** le mouvement de fermeture de la porte de sas (47), le mouvement de coulissement de la table de réception (45), le mouvement d'abaissement de la voie à rouleaux (75) sont dérivés d'un mécanisme à manivelle de même type.

21. Dispositif selon la revendication 20, **caractérisé en ce que** les unités d'entraînement pour le mouvement de fermeture de la porte de sas (47), pour le mouvement de coulissement de la table de réception (45) et pour le mouvement d'abaissement de la voie à rouleaux (75) et de la porte de sas (47) sont disposées à l'intérieur du dispositif à sas (14).
